# EUROPEAN PATENT APPLICATION

(11) **EP 4 667 114 A1**
(43) Date of publication of application: **24.12.2025**
(21) Application number: 24210832.2
(22) Date of filing: 05.11.2024
(51) Int. Cl.: B05B 5/00, B05B 5/025, B05B 5/03, B05B 7/08, B05B 7/16, B05B 12/10, B05D 3/04, B29C 64/00, G05D 24/02

(54) **LIQUID MATERIAL DISPENSING APPARATUS**

(30) Priority: 18.06.2024 KR 20240078795
(71) Applicant: Enjet Co., Ltd., Gyeonggi-do 16643 (KR)
(72) Inventor: BYUN, Do Young, 06280 Seoul (KR); NGUYEN, Vu Dat, 16356 Gyeonggi-do (KR); JEON, Kwangsun, 16685 Gyeonggi-do (KR)
(74) Representative: Jostarndt Patentanwalts-AG

(57) **Abstract**

The present disclosure relates to a liquid material dispensing apparatus, and the liquid material dispensing apparatus according to the present disclosure is characterized to include a nozzle part that dispenses a liquid material; a liquid material storage part that is connected to the nozzle part and contains the liquid material; a first temperature adjustment part that is arranged in the nozzle part in order to adjust a temperature of the liquid material passing through the nozzle part; and a gas supply part that supplies a heated or cooled gas towards a liquid material application site in order to control a temperature of the liquid material application site.

## Description

### 1. Field

The present disclosure relates to a liquid material dispensing apparatus, and more particularly, to a liquid material dispensing apparatus that can improve the application quality of a liquid material by supplying a temperature-controlled gas towards a site subject to application.

### 2. Background

In general, in a process for manufacturing an electronic product, a process for applying a liquid material to a target may be performed.

For example, the liquid material may be dispensed as an adhesive for bonding semiconductor components, or the liquid material may be applied to a fixing area of an electronic device in order to perform an underfill process to fill a gap between the electronic device and a substrate. In the case of a process of manufacturing an LED device, by dispensing, on an LED chip, a liquid material having the form of a fluorescent liquid where a fluorescent material has been mixed, optical characteristics of the LED device are controlled.

An underfill process is a process of filling a filler having a liquid form into an empty space between an electronic device and a substrate after the bonding of the electronic device in order to prevent the device from being damaged due to physical shock, chemical shock, and rapid temperature changes in various semiconductor package types such as flip-chip, Ball Grid Array (BGA), and Chip Scale Package (CSP).

In this way, a dispenser dispenses various types of liquid materials, mostly silicone or epoxy-based liquid materials.

A conventional dispenser is composed of a head having a storage container for accommodating a liquid material and a nozzle for discharging the liquid material, and a moving device that moves the head horizontally and/or vertically with respect to an object. The head may use an air pressure method that uses air pressure to pressurize the liquid material stored in the storage container located at a rear end of the nozzle in the direction of the nozzle and discharges the liquid material by controlling the opening and closing of a valve arranged between the storage container and the nozzle, or a piezo method, where power is selectively applied to a piezoelectric actuator arranged at the rear end of the nozzle, and physical deformation of the piezoelectric actuator is induced, thereby discharging the liquid material.

Such a dispenser has a limitation in the viscosity of the liquid material that can be dispensed depending on the discharge method, and thus by heating the liquid material and thereby reducing the viscosity, the application performance of the liquid material can be improved.

However, conventional dispensers take the method of heating the liquid material contained in the storage container to a predetermined temperature in order to lower the viscosity of the liquid material.

In such a conventional dispenser, since the nozzle part cannot be heated, the liquid material is cooled during the process where the liquid material passes through the nozzle, and further, the liquid material discharged from the nozzle can be additionally cooled in the process of being dispensed towards the target and being applied. Especially, in the case where such a dispenser is used in an underfill process, the liquid material having viscosity can be cooled in the discharging process, in which case the spreadability of the liquid material will deteriorate, causing reduced speed of filling into a lower gap of the electronic device and incomplete filling, and such incomplete filling may cause a void between the substrate and the electronic device, causing a fatal flaw.

### [PRIOR ART LITERATURE]

### [PATENT DOCUMENT]

Korean Patent Registration No. 10-2047025

### SUMMARY

Therefore, a purpose of the present disclosure is to resolve the aforementioned problems of prior art, that is, to provide a liquid material dispensing apparatus that can improve the application quality of a liquid material by supplying a temperature-controlled gas to a nozzle part or an application object site.

The aforementioned purpose according to the present disclosure is achieved by a liquid material dispensing apparatus including a nozzle part that discharges a liquid material; a liquid material storage part that is connected to the nozzle part and contains the liquid material; a first temperature adjustment part that is arranged in the nozzle part in order to adjust a temperature of the liquid material passing through the nozzle part; and a gas supply part that supplies a heated or cooled gas towards a liquid material application site in order to control a temperature of the liquid material application site.

Here, it is preferable that the liquid material dispensing apparatus further includes a heat conduction block arranged between the first temperature adjustment part and the nozzle part.

Further, it is preferable that the heat conduction block includes a supply passage through which the gas supplied through the gas supply part can pass.

Further, it is preferable that the supply passage includes a heat-exchange passage that is arranged in a direction parallel to a central axis of the nozzle part, a gas supply port that is connected with the heat-exchange passage at a rear end side of the nozzle part and a gas discharge port that is connected with the heat-exchange passage at a front end side of the nozzle part.

Further, it is preferable that the gas discharge port is arranged in a shape surrounding the nozzle part at a front surface portion of the heat conduction block facing a target.

Further, it is preferable that the gas discharge port is arranged at an angle with respect to the central axis of the nozzle part so as to concentrate the gas towards the liquid material application site.

Further, it is preferable that the liquid material dispensing apparatus further includes an electric field forming part that can form a potential difference between the liquid material and a target so that the nozzle part can discharge the liquid material in an Electro Hydro Dynamic method.

Further, it is preferable that the liquid material dispensing apparatus further includes an electrical insulation part arranged between the first temperature adjustment part and the heat conduction block.

Further, it is preferable that the nozzle part is configured to discharge the liquid material in at least any one method of an air pressure method, a jet-valve method, a screw pump method, and a syringe pump method.

Further, it is preferable that the liquid material dispensing apparatus further includes a second temperature adjustment part that is arranged in the liquid material storage part in order to adjust a temperature of the liquid material contained in the liquid material storage part.

Further, it is preferable that the gas supply part supplies the gas towards a top surface of the liquid material application site from an outer side of the nozzle part.

Further, it is preferable that the gas supply part supplies the gas towards a flow direction of the liquid material from the outer side of the nozzle part so that the liquid material applied to a target can flow in a purpose direction.

According to the present disclosure, a liquid material dispensing apparatus is provided, that can supply a gas that is controlled to a set temperature, towards an object site for liquid material discharge, so that the temperature is prevented from changing in the process where the liquid material having viscosity is discharged through the nozzle part, and through this, application quality of the liquid material can be improved.

### BRIEF DESCRIPTION OF THE DRAWINGS

FIG. 1 is a configuration diagram of a liquid material dispensing apparatus according to a first embodiment of the present disclosure;
FIG. 2 is a cross-sectional view showing a state of use of the liquid material dispensing apparatus shown in FIG. 1;
Fig. 3 is a cross-sectional view showing an operation of FIG. 1
FIG. 4 is a cross-sectional view of a liquid material dispensing apparatus according to a second embodiment of the present disclosure;
FIG. 5 is a cross-sectional view of a liquid material dispensing apparatus according to a third embodiment of the present disclosure; and
FIG. 6 is an image for explaining action effects of the gas supply part according to the present disclosure.

From now, an operation of a first embodiment of the liquid material dispensing apparatus described above will be described.

### DETAILED DESCRIPTION

Prior to explanation, it is to be noted that, in various embodiments, components having the same configuration will be representatively described in the first embodiment using the same reference numerals, and in other embodiments, configurations different from the first embodiment will be described.

Hereinbelow, a liquid material dispensing apparatus according to the first embodiment of the present disclosure will be described in detail with reference to the drawings attached.

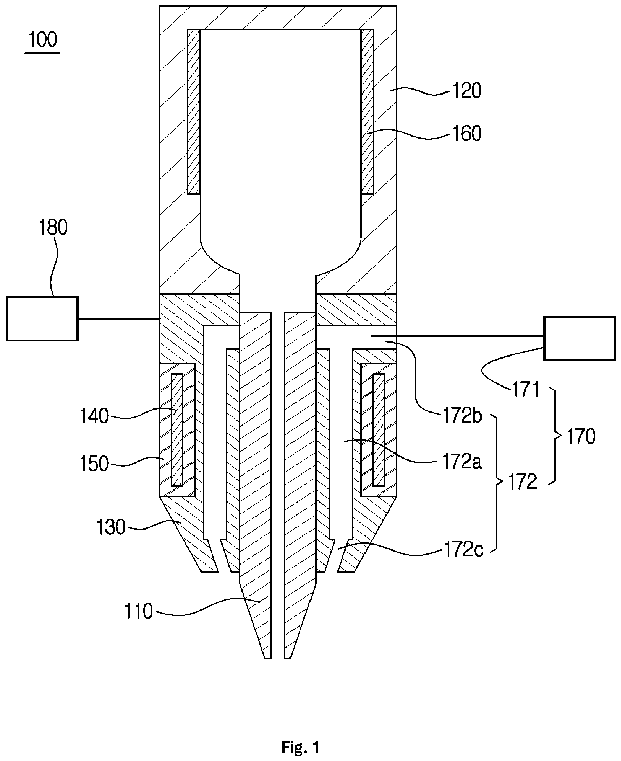

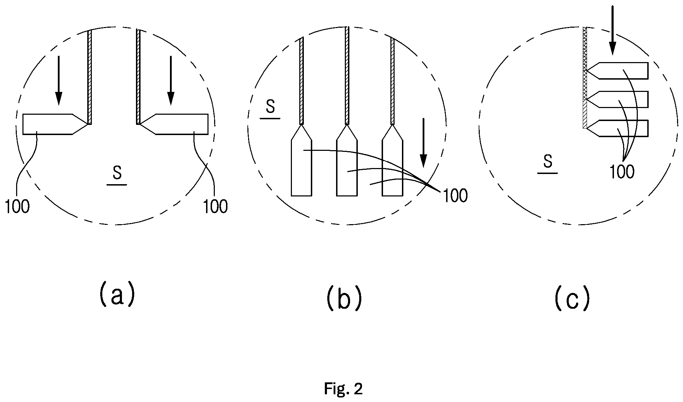

Of the attached drawings, FIG. 1 is a configuration diagram of a liquid material dispensing apparatus according to the first embodiment of the present disclosure, and FIG. 2 is a cross-sectional view showing a state of use of the liquid material dispensing apparatus shown in FIG. 1.

The liquid material dispensing apparatus of the present disclosure as shown in the aforementioned drawings includes a nozzle part 110, a liquid material storage part 120, a heat conduction block 130, a first temperature adjustment part 140, a second temperature adjustment part 160 and a gas supply part 170.

The nozzle part 110 may be made in a tube form in order to discharge a liquid material, and inside the nozzle part 110, a passage through which the liquid material can pass is formed, and at a front end portion facing a target, a discharge hole is formed.

The nozzle part 110 may be configured to discharge the liquid material in various methods such as air pressure, Electro Hydro Dynamic (EHD), jet-valve, screw-pump, and syringe-pump.

For example, in the case of the Electro Hydro Dynamic (EHD) method that discharges a liquid material by the power of an electric field, a potential difference with respect to a target can be formed using an electric field forming part 180.

Such an electric field forming part 180 may be configured in the method of applying a high voltage to the nozzle part 110 in order to charge the liquid material being discharged from the nozzle part 110, or otherwise, may be configured to apply a high voltage to the target in order to form a potential difference between the liquid material and the target, or in the method of applying a high voltage having a potential difference to the nozzle part 110 and the target, respectively. Further, it is also possible to configure such that a high voltage is applied to a stage that supports a lower portion of the target in order to apply the high voltage to the target side. The discharge technology using such Electro Hydro Dynamic (EHD) method is well known through Patent Registration No. 10-2047025 and the like, and thus detailed description thereof will be omitted.

The Electro Hydro Dynamic (EHD) method may also be combined with other discharge methods in a hybrid form. For example, discharge performance can be improved by applying a high voltage to the nozzle part 110 that uses a conventional air pressure or piezoelectric method, thereby charging the liquid material.

The liquid material storage part 120 forms a containing space for containing the liquid material inside it, and may be made in a barrel form that is connected to a rear end side of the nozzle part 110 in order to supply the liquid material to the nozzle part 110.

Meanwhile, the liquid material storage part 120 may be connected to a separate storage tank, pipe and the like in order to continuously receive the liquid material.

The first temperature adjustment part 140 is for maintaining the temperature of the liquid material passing through the nozzle part 110 to a preset temperature, and may be arranged on a side outline of the nozzle part 110, and may include a heating/endothermic device that can heat or cool the nozzle part 110. Such a first temperature adjustment part 140 may be controlled to operate based on a value measured by a temperature sensor that measures at least any one of the temperature of the liquid material being discharged from the nozzle part 110, and the temperature of the heating /endothermic device.

The second temperature adjustment part 160 is for controlling the viscosity of the liquid material depending on the characteristics of the liquid material, the nature of the target, the work environment, or the purpose of work and the like, and the second temperature adjustment part 160 may include a heating/endothermic device that can heat or cool the liquid material contained in the liquid material storage part 120 to a preset temperature. Such a second temperature adjustment part 160 may be controlled to operate based on a value measured by the temperature sensor that measures at least any one of the temperature of the liquid material contained in the liquid material storage part 120, preferably the temperature of the liquid material being supplied to the nozzle 110, and the temperature of the heating/endothermic device.

Specifically, the second temperature adjustment part adjusts the temperature of the liquid material so that the liquid material contained in the liquid material storage part 120 has a target viscosity, and the first temperature adjustment part 140 adjusts the temperature of the nozzle part 110 so that the liquid material whose temperature is controlled by the second temperature adjustment part 160 can maintain a constant temperature in the process of passing through the nozzle part 110. For example, when the temperature of the liquid material is raised through the second temperature adjustment part 160, the viscosity of the liquid material is lowered, and the fluidity is increased.

The heating device may be a cartridge heater, a plate (ceramic) heater, a fluid heating heater, a rubber (or silicone) heater, a non-contact heater, etc., and the endothermic device may be a Peltier device, an air-cooled or water-cooled cooler using a cooling medium, etc.

Meanwhile, in order for the heat energy provided by the first temperature adjustment part 140 to be effectively transferred to the nozzle part 10, a heat conduction block 130 may be arranged between the first temperature adjustment part 140 and the nozzle part 110.

Such a heat conduction block 130 is made of a material with excellent heat conductivity to effectively transfer the heat energy, and may be arranged to surround a side outline of the nozzle part 110.

Between the first temperature adjustment part 140 and the heat conduction block 130, an electrical insulation part 150 may be arranged to electrically insulate the first temperature adjustment part 140 from the heat conduction block 130. Accordingly, the first temperature adjustment part 140 can be prevented from being affected by the high voltage applied by the electric field forming part 180. In addition, the liquid material storage part 120 is also preferably made of an electrically insulating material so as not to be affected by the high voltage caused by the electric field forming part 180.

The gas supply part 170 may supply gas that is controlled to a set temperature towards the liquid material application site to control the temperature of the liquid material application site.

Such a gas supply part 170 may include a gas pump 171 for supplying gas and a supply passage 172 that discharges the gas supplied by the gas pump 171 towards the liquid material application site. In this embodiment, explanation is made based on an example that the supply passage 172 is formed to pass through the inside of the heat conduction block 130 so that the temperature of the gas passing through the supply passage 172 can be adjusted by the first temperature adjustment part 140.

The supply passage 172 includes a heat-exchange passage 172a that is arranged in a direction parallel to a central axis of the nozzle part 110 inside the heat conduction block 130, a gas supply port 172b that is connected with the heat-exchange passage 172a at a rear end side of the nozzle part 110, and a gas discharge port 172c that is connected with the heat-exchange passage 172a at a front end side of the nozzle part 110 and discharges gas.

The heat-exchange passage 172a is for heat-exchange of gas with the heat conduction block 130, and may be made in a heat-exchanger form that is based on a micro channel, and may be made in a heat-exchange structure such as a plate, spiral, etc.

In the drawings of this embodiment, the heat-exchange passage 172a is shown as an example of being arranged inside the heat conduction block 130, that is, in an area between the nozzle part 110 and the first temperature adjustment part 140, but there is no limitation thereto, and it may be possible to arrange it in a form that it surrounds an outer side of the heat conduction block 130.

The gas discharge port 172c is arranged on a front surface portion of the heat conduction block 130 facing the target. A plurality of this gas discharge port 172c may be arranged on a circumference that is concentric with the central axis of the nozzle part 110, or may be arranged in an annular shape that is concentric with the central axis of the nozzle part 110, and may discharge the gas in an inclined direction with respect to the central axis of the nozzle part so as to concentrate the gas to the liquid material application site.

That is, the liquid material that is discharged from the nozzle part 110 and applied to the object site is being applied to the object site under a temperature atmosphere that is set by the gas that is concentric with the central axis of the nozzle part 110 and that is arranged in the form surrounding a movement path of the liquid material, and thus may not only prevent the viscosity characteristics from changing due to cooling during the discharge process, but also prevent the application quality from changing depending on the external environment.

The nozzle part 110 is a device that forms a predetermined pattern by attaching the liquid material sprayed from the nozzle to the target (printing object), and in this embodiment, it was described based on an example that it uses the Electro Hydro Dynamic (EHD) method, but there is no limitation thereto, and may be configured to discharge the liquid material in various methods such as air pressure, jet-valve, screw-pump, and syringe-pump, etc.

The air pressure method may include an air compressor that supplies compressed air, a regulator that adjusts the pressure of the compressed air, a storage container that stores the liquid material, a valve that adjusts the discharge amount of the liquid material, a nozzle that discharges the liquid material, and a control part that controls the operation of the regulator and the valve.

The jet-valve method may include a storage container for storing the liquid material, an actuator that opens and closes the valve using a piezo or solenoid method, a valve body including a spray passage connected to the actuator, a nozzle that sprays the liquid material at an end of the spray passage, and a control part that controls the operation of the actuator.

The screw pump method may include a storage container for storing the liquid material, a screw that pushes the liquid material through rotational movement, a motor that provides power to rotate the screw, a nozzle that discharges the liquid material, and a control part that controls the rotation speed and direction of the screw.

The syringe pump method may include a syringe that stores the liquid material, a pump mechanism that precisely pushes or pulls a piston, a motor that provides power to drive the pump mechanism, a nozzle that discharges the liquid material, and a control part that controls the operation of the pump.

The nozzle part 110 of this embodiment may use at least any one of the aforementioned Electro Hydro Dynamic (EHD) method, air pressure method, jet-valve method, screw-pump method and syringe pump method depending on the characteristics of the liquid material that is the object of discharge, characteristics of the target and working environment, etc., and since the detailed configurations and operating principle of each method are well-known technology, detailed description thereof will be omitted.

Meanwhile, although not shown in the drawings, the liquid material dispensing apparatus of this embodiment may include a moving part that moves at least any one of the nozzle part 110 and target, for the movement of the liquid material application site. The moving part may be configured to transfer at least any one of the nozzle part 110 and the target in XYZ directions. For example, the moving part may be configured to transfer the nozzle part 110 in XYZ directions, or to transfer a stage that supports the target, in XYZ directions. Further, the moving part may be configured to move the stage in Z direction and move the nozzle part 110 in XY directions, or to move the stage in XY directions and move the nozzle part 110 in Z direction, and may also be configured to rotate the stage horizontally.

Further, it may include at least any one of an inclination adjustment part that can adjust the inclination of the nozzle part 110, a distance sensor that measures the distance between the nozzle part 110 and the target, and an image acquisition part that acquires real-time image information of the liquid material application site.

Further, the nozzle part 110, liquid material storage part 120, heat conduction block 130, first temperature adjustment part 140, second temperature adjustment part 160, and gas supply part 170 may be provided in a dispensing module 100 form modularized in one unit.

A plurality of such dispensing module 100 may be provided, and these plurality of dispensing modules 100 may be arranged in a symmetrical form around the image acquisition part as in (a) of FIG. 2, or may be arranged in a parallel form with respect to the application direction of the liquid material as in (b) of FIG. 2, and may be arranged in a serial form with respect to the application direction of the liquid material (arranged in a row and spaced apart along the application direction) as in (c) of FIG. 2. When the plurality of dispensing modules 100 are arranged in the symmetrical form or parallel form, it is possible to apply the liquid material from different locations from one another, and when arranged in the serial form, it is possible to apply the liquid material in an overlapping manner using the plurality of dispensing modules 100.

Further, it is preferable that the plurality of dispensing modules 100 are configured to each independently discharge the liquid material, and that the inclination and XYZ direction movement positions are individually controlled by the inclination adjustment part and the transfer part.

When configured as described above such that the liquid material is discharged using each of the plurality of dispensing modules 100, the speed and productivity of the application process can be further improved.

From now, an operation of a first embodiment of the liquid material dispensing apparatus described above will be described.

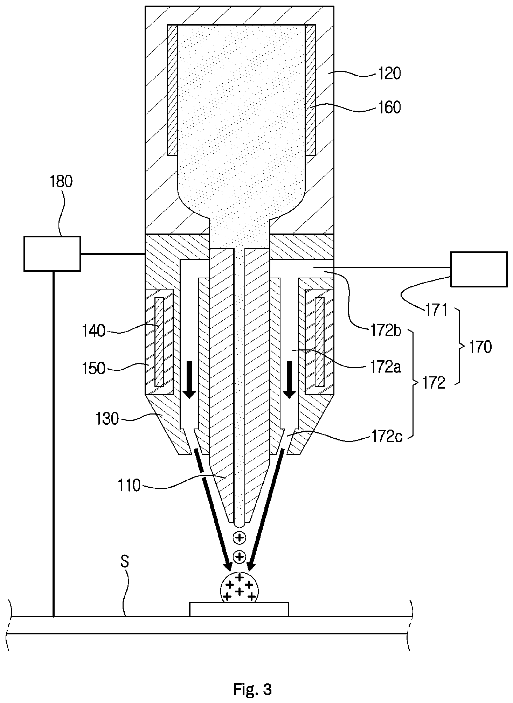

As shown in FIG. 3, the nozzle part 110 may receive a liquid material from the liquid material storage part 120 connected to a rear end, and discharge it towards a target in the front direction.

The second temperature adjustment part 160 arranged within the liquid material storage part 120 is controlled to adjust the temperature of the liquid material in order to control the viscosity of the liquid material contained inside the liquid material storage part 120.

Further, the first temperature adjustment part 140 arranged in the form of surrounding a side outline of the nozzle part 110 is controlled to adjust the temperature of the nozzle part 110 so that the temperature does not change in the process where the liquid material passes through the nozzle part 110, and the heat conduction block 130 for effectively transmitting heat energy is arranged between the second temperature adjustment part 160 and the nozzle part 110.

That is, the nozzle part 110 that is temperature-controlled by the first temperature adjustment part 140 can maintain the set temperature of the liquid material in the process of passing the liquid material that is controlled to the set temperature in the liquid material storage part 120, and thus it is possible to minimize the effect of the external environment in the liquid material application process and provide a consistent application quality.

Further, the gas supply part 170 may provide the temperature-controlled gas from the periphery of the nozzle part 110 towards the liquid material application site.

A plurality of gas discharge ports 172c of such a gas supply part 170 may be arranged along a circumference that is concentric with the central axis of the nozzle part 110, or may be formed in an annular shape that is concentric with the central axis of the nozzle part 110, and the gas discharge direction of the gas discharge port 172c is set to concentrate the gas towards the liquid material application site.

That is, the gas being discharged from the gas discharge port 172c is discharged in the form of surrounding the liquid material discharge path between the nozzle part 110 and the target. Here, since the gas provided towards the liquid material application site by the gas supply part 170 is provided at a preset temperature and can function as a barrier to block temperature changes caused by the external environment, it is possible to prevent the temperature of the liquid material from changing due to the external environment in the process where the liquid material is dispensed from the nozzle part 110 to the target and applied.

The gas being provided through the gas supply part 170 may be controlled to the set temperature as it passes through the supply passage 172 that bypasses the heat conduction block 130.

Specifically, the gas being provided from the gas pump 171 is provided to the heat-exchange passage 172a formed inside the heat conduction block 130 through the gas supply port 172b formed at a rear end side of the heat conduction block 130, and the gas that passed through the heat-exchange passage 172a may be discharged towards the liquid material application site through the gas discharge port 172c formed at a front end of the heat conduction block 130, and in the process of passing through the heat-exchange passage 172a, may perform a heat-exchange with the heat conduction block 130 to be controlled to the target temperature.

That is, the gas being discharged through the gas supply part 170 may perform the heat-exchange with the heat conduction block 130 surrounding the nozzle part 110, to be controlled to substantially the same temperature as the temperature of the liquid material being discharged from the nozzle part 110. Accordingly, by the gas discharged through the gas supply part 170, the periphery of the liquid material discharge path between the nozzle part 110 and the target is set to the same temperature atmosphere as the liquid material, and thus it is possible to prevent the liquid material from being affected by the ambient temperature of the apparatus in the process where the liquid material discharged from the nozzle part 110 is applied to the target, and it is possible to prevent the liquid material from being cooled and reducing the spreadability in the process of being discharged through the nozzle part 110.

Next, a liquid material dispensing apparatus according to a second embodiment of the present disclosure will be explained.

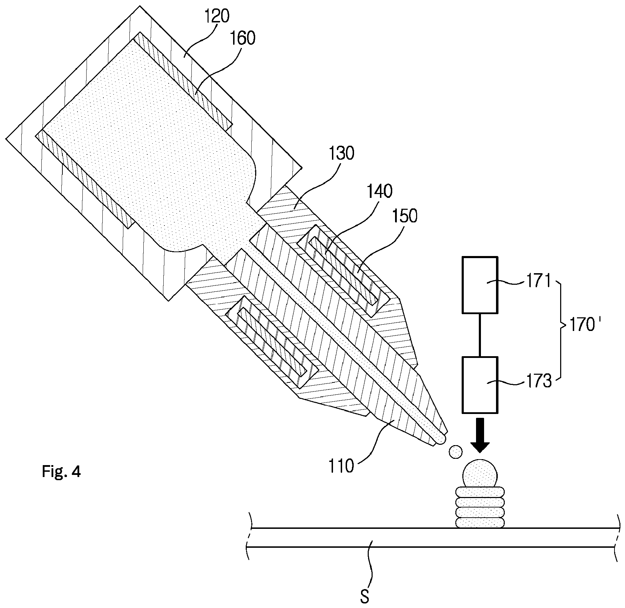

FIG. 4 is a cross-sectional view of the liquid material dispensing apparatus according to the second embodiment of the present disclosure.

The liquid material dispensing apparatus according to the second embodiment of the present disclosure is different from the first embodiment in terms of configuration in that the gas supply part 170' is configured to be separate from the heat conduction block 130, and that the gas is discharged towards a top surface of the liquid material application site from outside of the nozzle part 110.

The gas supply part 170' may include a gas pump 171 that supplies gas at a predetermined pressure, and a gas discharge part 173 that, from a position close to the nozzle part 110, discharges the gas received from the gas pump 171 towards the top surface of the liquid material application site.

The temperature of the gas being discharged from the gas supply part 170' may be controlled according to the purpose of usage, and for this purpose, a temperature adjustment part for adjusting the temperature of the gas may be arranged between the gas pump 171 and the gas discharge part 173. For example, the temperature adjustment part provided in the gas supply part 170' may control the gas being provided to the gas discharge part 173 to a lower temperature than the liquid material for the purpose of shortening the curing of the liquid material applied to the target, or control the gas being provided to the gas discharge part 173 to a higher temperature than the liquid material for the purpose of delaying the curing of the liquid material applied to the target or of improving the liquidity of the liquid material.

Especially, since controlling the temperature of the gas to a lower temperature than the liquid material, thereby shortening the curing of the applied liquid material, enables prompt curing of the liquid material applied to the target, it is effective in reducing the process time in the process of applying the liquid material to the target to generate a three-dimensional stacked structure.

Next, a liquid material dispensing apparatus according to a third embodiment of the present disclosure will be described.

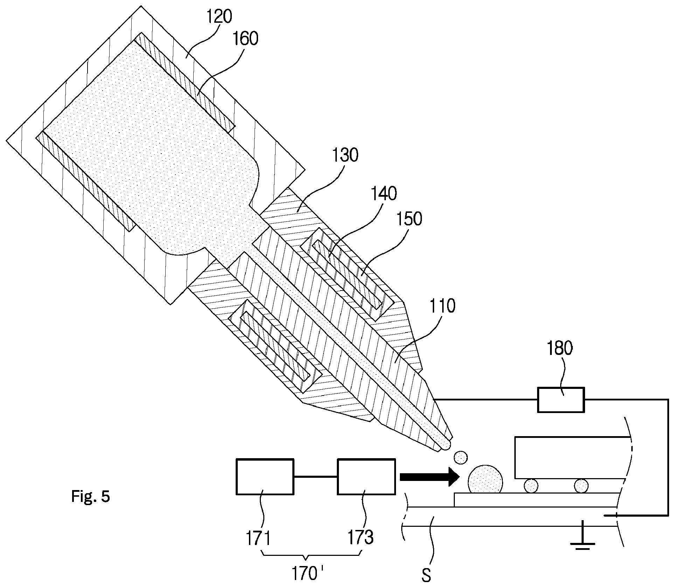

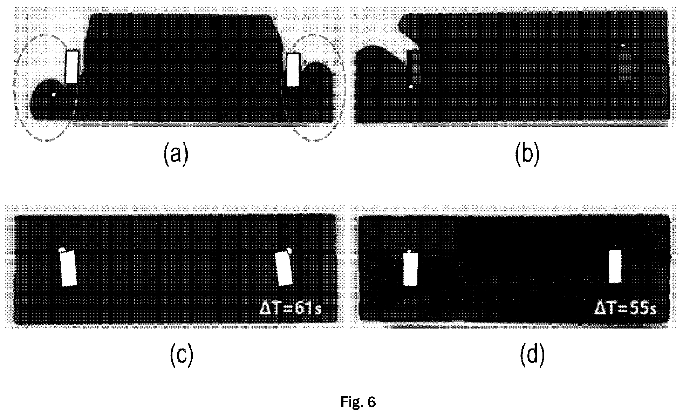

FIG. 5 is a cross-sectional view of a liquid material dispensing apparatus according to the third embodiment of the present disclosure, and FIG. 6 is an image for explaining action effects of the gas supply part according to the present disclosure.

The liquid material dispensing apparatus according to the third embodiment of the present disclosure is different from the second embodiment in terms of configuration in that the gas supply part 170' is configured to supply gas from outside of the nozzle part 110, towards a side surface of the liquid material application site, that is, a capillary flow direction of the liquid material.

The gas supply part 170' may include a gas pump 171 that supplies gas, and a gas supply part 173 that discharges the gas received from the gas pump 171 towards the side surface of the liquid material application site from a position close to the nozzle part 110 that discharges the liquid material towards the liquid material application site of the target.

In this embodiment, the nozzle part 110 may be configured to discharge the liquid material in the Electro Hydro Dynamic (EHD) method, and the gas supply part 170' may be set to face the flow direction of the liquid material applied to the target.

For example, when the liquid material dispensing apparatus of this embodiment is applied to an underfill process for filling a gap between an electronic device and a substrate, the liquid material for performing a filling function to a side surface of the electronic device can be applied through the nozzle part 110. The liquid material applied to the target fills the space between the electronic device and the substrate as it spreads into the space between the electronic device and the substrate by capillary force.

However, in the case of the underfill method using the capillary force, filling is determined by the relationship of the surface tension between the electronic device and the substrate and the viscous force, and thus the filling may take a lot of time and may result in an incomplete filling depending on the characteristics of the liquid material. In particular, when the height of a bump is lowered, the surface area of the filler liquid level decreases and the surface tension decreases, whereas the viscous force acting on the surface of the electronic device and substrate is the same, which may lead to a decrease in filling speed and incomplete filling. The incomplete filling creates a void between the substrate and the electronic device, resulting in a fatal defect.

That is, according to this embodiment, the temperature of the liquid material can be controlled through the first temperature adjustment part 140 and the second temperature adjustment part 160, and thus it is possible to improve the liquidity of the liquid material having viscosity, and it is possible to prevent such a liquid material from cooling during the discharge process. Not only that, by providing a pressing force in the direction of the capillary flow of the applied liquid material using gas, the penetration of the liquid material can be improved, thereby minimizing the creation of voids between the electronic device and the substrate and shortening the underfill filling time.

FIG. 6 shows the degree of filling of the liquid material between the electronic device and the substrate in the underfill process.

Specifically, (a) of FIG. 6 shows a state where the liquid material discharged in an air pressure method or piezo method flows between the electronic device and the substrate, and (b) of FIG. 6 shows a state where the liquid material flows between the electronic device and the substrate while discharging the liquid material in the Electro Hydro Dynamic method at the same time of supplying the heated gas in the flow direction of the liquid material through the gas supply part 170.

That is, in (b) of FIG. 6, the diffusion of liquid material between the electronic device and the substrate is induced by electrocapillary force, and thus diffusion of liquid material can be improved compared to when relying only on capillary force as shown in (a) of FIG. 6. In addition, not only is the temperature of the liquid material kept constant by the heated gas provided to the discharged liquid material, but it is also pressurized in the direction of flow by the discharge pressure of the gas, which further improves the diffusion of the liquid material between the electronic device and the substrate. Meanwhile, since the effect of improving the filling efficiency by controlling the wettability of the filler using an electric field is known through Patent Registration 10-2047025, detailed description thereof will be omitted.

Further, (c) and (d) of FIG. 6 each shows a state where the liquid material is applied in the Electro Hydro Dynamic method, wherein (c) of FIG. 6 is an image displaying the time it takes for the liquid material to be completely filled in the space between the electronic device and the substrate in a state where a gas is not supplied through the gas supply part, and (d) of FIG. 6 is an image displaying the time it takes for the liquid material to be completely filled in the space between the electronic device and the substrate with a heated gas supplied in the flow direction of the liquid material through the gas supply part 170.

As shown in (c) of FIG. 6, when the gas supply part 170' is not used, it takes 61 seconds for the liquid material to be completely filled, whereas as shown in (d) of FIG. 6, when gas is discharged in the flow direction of the liquid material through the gas supply part 170, it takes 55 seconds for the liquid material to be completed filled. That is, as shown in (d) of FIG. 6, when the liquid material is applied in the Electro Hydro Dynamic method and the gas is discharged in the flow direction of the liquid material through the gas supply part 170', in addition to the electrocapillary effect caused by the Electro Hydro Dynamic method, the temperature of the liquid material is maintained constant by the heated gas and is pressurized in the filling direction, making the diffusion of the liquid material in the filling direction more active, and accordingly, the filling time of the liquid material can be effectively shortened in the underfill process.

Meanwhile, the gas being supplied through the gas supply part 170 may be heated to a higher temperature than the liquid material being applied to the target, and then discharged towards the nozzle part or the liquid material application site, thereby inducing the diffusion of the liquid material applied to the target more actively.

The scope of the present disclosure is not limited to the above-described embodiments, but may be implemented in various forms of embodiments within the scope of the appended claims. It is deemed to be within the scope of the claims of the present disclosure to the extent that anyone skilled in the art can make modifications without departing from the gist of the present disclosure as claimed in the claims.

### [REFERENCE NUMERALS]

110: NOZZLE PART, 120: LIQUID MATERIAL STORAGE PART, 130: HEAT CONDUCTION BLOCK, 140: FIRST TEMPERATURE ADJUSTMENT PART, 150: ELECTRICAL INSULATION PART, 160: SECOND TEMPERATURE ADJUSTMENT PART, 170: GAS SUPPLY PART, 171: GAS PUMP, 172: SUPPLY PASSAGE, 172A: HEAT-EXCHANGE PASSAGE, 172B: GAS SUPPLY PORT, 172C: GAS DISCHARGE PORT, 173: GAS DISCHARGE PART, 180: ELECTRIC FIELD FORMING PART

## Claims

1. A liquid material dispensing apparatus **characterized in** comprising:
a nozzle part 110 that discharges a liquid material;
a liquid material storage part 120 that is connected to the nozzle part 110 and contains the liquid material;
a first temperature adjustment part 140 that is arranged in the nozzle part 110 in order to adjust a temperature of the liquid material passing through the nozzle part 110; and
a gas supply part 170 that supplies a heated or cooled gas towards a liquid material application site in order to control a temperature of the liquid material application site.

2. The liquid material dispensing apparatus according to claim 1,
further comprising a heat conduction block 130 arranged between the first temperature adjustment part 140 and the nozzle part 110.

3. The liquid material dispensing apparatus according to claim 2,
wherein the heat conduction block 130 comprises a supply passage 172 through which the gas supplied through the gas supply part 170 can pass.

4. The liquid material dispensing apparatus according to claim 3,
wherein the supply passage 172 comprises a heat-exchange passage 172a that is arranged in a direction parallel to a central axis of the nozzle part 110, a gas supply port 172b that is connected with the heat-exchange passage 172a at a rear end side of the nozzle part 110 and a gas discharge port 172c that is connected with the heat-exchange passage 172a at a front end side of the nozzle part 110.

5. The liquid material dispensing apparatus according to claim 4,
wherein the gas discharge port 172c is arranged in a shape surrounding the nozzle part 110 at a front surface portion of the heat conduction block 130 facing a target.

6. The liquid material dispensing apparatus according to claim 5,
wherein the gas discharge port 172c is arranged at an angle with respect to the central axis of the nozzle part 110 so as to concentrate the gas towards the liquid material application site.

7. The liquid material dispensing apparatus according to claim 2,
further comprising an electric field forming part 180 that can form a potential difference between the liquid material and a target so that the nozzle part 110 can discharge the liquid material in an Electro Hydro Dynamic method.

8. The liquid material dispensing apparatus according to claim 7,
further comprising an electrical insulation part 150 arranged between the first temperature adjustment part 140 and the heat conduction block 130.

9. The liquid material dispensing apparatus according to any one of claims 1 to 6,
wherein the nozzle part 110 is configured to discharge the liquid material in at least any one method of an air pressure method, a jet-valve method, a screw pump method, and a syringe pump method.

10. The liquid material dispensing apparatus according to claim 1,
further comprising a second temperature adjustment part 160 that is arranged in the liquid material storage part 120 in order to adjust a temperature of the liquid material contained in the liquid material storage part 120.

11. The liquid material dispensing apparatus according to claim 1,
wherein the gas supply part 170 supplies the gas towards a top surface of the liquid material application site from an outer side of the nozzle part 110.

12. The liquid material dispensing apparatus according to claim 1,
wherein the gas supply part 170 supplies the gas towards a flow direction of the liquid material from the outer side of the nozzle part 110 so that the liquid material applied to a target can flow in a purpose direction.

13. The liquid material dispensing apparatus according to any one of claims 1 to 8 and 10 to 12,
wherein the nozzle part 110, liquid material storage part 120, first temperature adjustment part 130 and gas supply part 170 are provided in a module form.

14. The liquid material dispensing apparatus according to claim 13,
wherein the module is provided in multiple numbers, and is arranged symmetrically or in series or parallel with respect to an application direction of the liquid material.
